# EUROPÄISCHE PATENTSCHRIFT

(11) **EP 0 996 955 B1**
(45) Veröffentlichungstag und Bekanntmachung des Hinweises auf die Patenterteilung: **31.07.2002**
(21) Anmeldenummer: 98934831.3
(22) Anmeldetag: 29.05.1998
(51) Int. Cl.: H01C 1/16, H01C 7/13

(54) **HYBRIDSCHALTUNGSANORDNUNG MIT ÜBERLASTSICHERUNG**
HYBRID CIRCUIT ARRANGEMENT WITH OVERLOAD PROTECTION
DISPOSITIF DE CIRCUIT HYBRIDE A PROTECTION CONTRE LES SURCHARGES

(30) Priorität: 01.07.1997 DE 19728015
(43) Veröffentlichungstag der Anmeldung: 03.05.2000
(73) Patentinhaber: TYCO Electronics Logistics AG, 9323 Steinach (SG) (CH)
(72) Erfinder: REHNELT, Karl, D-81249 München (DE)
(74) Vertreter: Hirsch, Peter, Dipl.-Ing.
(86) Internationale Anmeldenummer: DE9801477
(87) Internationale Veröffentlichungsnummer: WO9901875

(56) Entgegenhaltungen:
- WO-A-89/03162
- DE-C- 4 143 095
- US-A- 4 041 440
- US-A- 4 467 310

## Beschreibung

Die Erfindung betrifft eine Hybridschaltungsanordnung gemäß Oberbegriff des Anspruchs 1.

Eine derartige Hybridschaltungsanordnung ist beispielsweise aus der WO-A-8 903 162 bekannt. Derartige Hybridschaltungen mit Schichtwiderständen werden insbesondere als Vor- bzw. Speisewiderstands-Netzwerke in Telekommunikationsanlagen eingesetzt und werden üblicherweise in Dickschicht- oder Dünnfilmtechnik hergestellt. Da Architekturen auf IC-Basis mittlerweile die herkömmlichen Architekturen auf Transformatorbasis ersetzt haben, sind derartige Telefonanlagen heutzutage empfindlicher denn je gegen Überspannungs- und Überstromrisiken in Fernsprechleitungen. Diese Überlastrisiken können vielfältige Ursachen haben, beispielsweise Blitzeinschläge, durch benachbarte Starkstromleitungen induzierte Stoßspannungen oder eine direkte Kopplung mit Starkstromleitungen.

Nach dem DE 931947341 werden als Sicherungen gegen zu große Langzeitbelastung bisher Thermosicherungen eingesetzt, die so ausgebildet sind, daß die im Überlastfall auftretende Verlustleistung zu einem Schmelzen einer Lötstelle führt, an der beispielsweise ein Federbügel der Sicherung festgelötet ist, so daß der unter Vorspannung festgelötete Federbügel wegschnellt und somit den Stromkreis unterbricht. Derartige Thermosicherungen sind zwar kostengünstig, jedoch ist nach einem Ansprechen der Sicherungen ein Austausch der gesamten Hybridschaltung notwendig. In Gegenden, wo aufgrund einer relativ schlechten Infrastruktur der Energie- und Kommunikationsnetze vermehrt Ausfälle auftreten, resultiert schnell ein nicht mehr vertretbarer Aufwand.

Aufgabe der vorliegenden Erfindung ist somit die Schaffung von Hybridschaltungen der eingangs genannten Art mit einem Sicherungssystem, das auch unter den Bedingungen einer relativ hohen Überlastfallrate und gegebenenfalls unter weiteren speziellen, durch die Anwendung im Telekommunikationsnetzen vorgegebenen Bedingungen wenig aufwendig ist.

Erfindungsgemäß wird dies bei einer Hybridschaltung der eingangs genannten Art durch die Kennzeichnungsmerkmale des Anspruchs 1 erreicht.

Kaltleiter sind nichtlineare Widerstände (keramische Halbleiter) mit einem sehr hohen positiven Temperaturkoeffizienten (PTC). Fremd- oder eigenerwärmte Kaltleiter werden für gewisse Schalt- und Regelaufgaben eingesetzt, sie sind jedoch aufgrund ihrer elektrischen und mechanischen Eigenschaften und ihrer Toleranzen nicht universell einsetzbar. Erfindungsgemäß werden Kaltleiter bei der eingangs genannten Hybridschaltungsanordnung als rückstellbare Schutzelemente eingesetzt, um die Sicherheit und Zuverlässigkeit der Anlagen, in die die Hybridschaltungen eingebaut sind, zu erhöhen und um die Wartungskosten zu senken. Wenn es zu einem Überlastfehler kommt, steigt der Widerstand des Kaltleiters von einer Basis von beispielsweise 25 Ω sehr schnell, d. h. innerhalb weniger Sekunden, auf einen wesentlich höheren Widerstand, der den Fehler isoliert. Nach Behebung des Fehlerzustandes und der Überspannung stellt sich der Kaltleiter selbständig'zurück und kann bei einem erneuten Störfall aufgrund des thermischen Kontakts zu den belasteten Schichtwiderständen (Fremderwärmung) oder direkt aufgrund eigener Verlustleistung erneut hochohmig werden.

Eine vorteilhafte Ausgestaltung der Erfindung ist in dem Unteranspruch beschrieben.

Zum besseren Verständnis der Erfindung und ihrer Weiterbildungen wird im folgenden ein Ausführungsbeispiele anhand einer Zeichnung erläutert. Es zeigen
- Figur 1, 2: - jeweils in einer Seitenansicht - zwei verschiedene Ausführungen eines auf einem Schaltungssubstrat angeordneten Kaltleiters, wobei lediglich Fig.2 eine Ausführungsform der Erfindung darstellt;
- Figur 3: - schematisch und vereinfacht - eine Draufsicht auf eine strukturierte und mit zwei Kaltleitern versehene Widerstandsschicht.

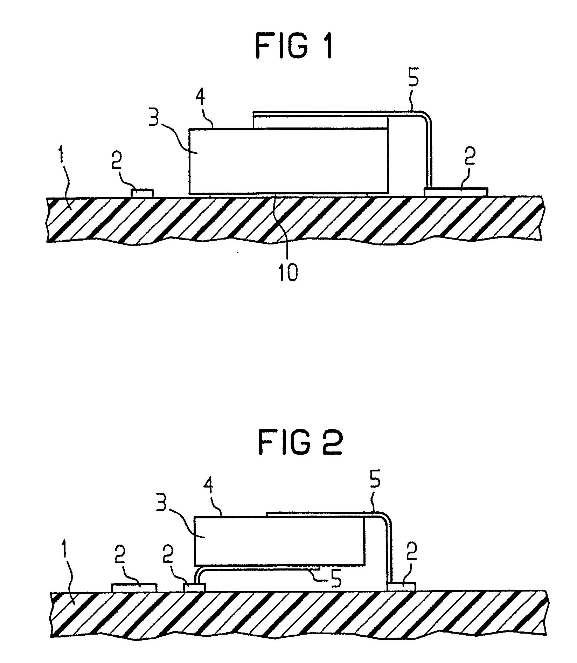

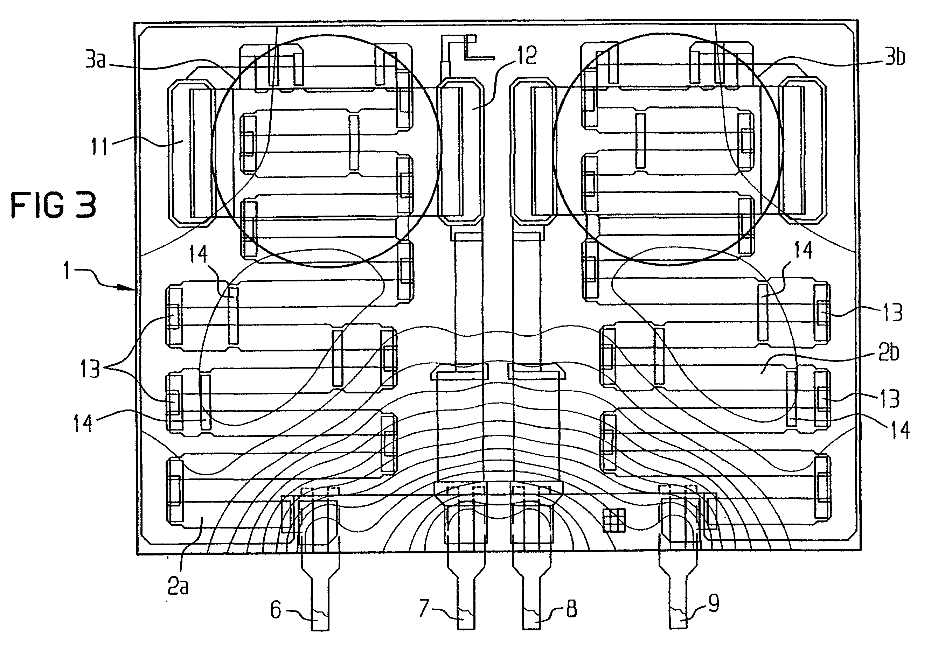

In Figur 1 ist ein vorzugsweise für ein Speisewiderstands-Netzwerk vorgesehener Kaltleiter 3 mit einer Anschlußfahne 5 dargestellt. Derartige Kaltleiter 3 sind typischerweise scheibenförmig und weisen auf ihren beiden Stirnflächen jeweils eine Kontaktfläche auf. Wie dargestellt, ist die obere Kontaktfläche 4 des Kaltleiters 3 über die Anschlußfahne 5 mit einer Leiterbahn bzw. mit der Widerstandsschicht 2 (vgl. Figur 3) des Substrats 1 verbunden. Der Durchmesser der Kaltleiterscheibe beträgt beispielsweise 5 mm und ihre Dicke 2 mm. Die untere Kontaktfläche des Kaltleiters 3 ist direkt auf der Widerstandsschicht 2 aufgelötet, so daß der Kaltleiter 3 durch die im Überlastungsfall auftretende Erwärmung des Substrats 1 fremderwärmt wird, Zu beachten ist, daß in allen Fehlerfällen, insbesondere aber bei Fremderwärmung, die Haftung des Kaltleiters 3 zum Substrat 1 gewährleistet sein muß, da die Scheibe auf keinen Fall abfallen und sich unkontrolliert in der Baugruppe bewegen darf. Bei Fremderwärinung müssen die Kaltleiter 3 außerdem einen sehr guten Wärmeleitwert zu den Schichtwiderständen 2 haben. Es ist deshalb vorteilhaft, wenn die Anschlußpins 6, 7 bzw. 8,9 der Schaltungsanordnung, vgl. Figur 3, und die Kaltleiter 3 soweit wie möglich auseinanderliegende Positionen auf dem Substrat 1 einnehmen. Gemäß Figur 3 werden die Kaltleiter 3 beispielsweise in den beiden Ecken entgegen der Pinseite plaziert, da an diesen Positionen der Wärmeabfluß über die Anschlußpins 6, 7, 8, 9 gering ist und so ein rasches Fremderwärmen der Kaltleiter 3 durch die Verlustleistung in der Widerstandsschicht 2 gewährleistet ist.

Ein schlechter Wärmeleitwert wird im übrigen oft durch Lunker in der Lötfläche 10 zwischen Kaltleiter 3 und Widerstandsschicht 2 verursacht. Es ist deshalb vorteilhaft, die Lötfläche 10 zwischen Kaltleiter 3 und Widerstandsschicht 2 mit Aussparungen zu versehen. Beispielsweise kann eine Druckmaske mit sternförmigen Aussparungen verwendet werden. Durch diese Aussparungen in der Lötfläche 10 können dann während der Reflow-Lötphase die entstehenden Gase entweichen, wodurch Lunker in der Lötfläche 10 weitgehend vermieden werden.

Eine Ausführungform der Erfindung des Kaltleiters 3 als oberflächenmontierbares Bauteil mit zwei Anschlußfahnen 5 ist in Figur 2 dargestellt. Die Kaltleiterscheibe hat ersichtlich keinen direkten Wärmekontakt zum Substrat 1, so daß der Kaltleiter 3 im Störfall unmittelbar durch die durch ihn fließende Überlastleistung hochohmig wird. Sowohl bei einem fremd-, wie bei einem eigenerwärmten Kaltleiter 3 wird der gleiche Schutzeffekt wie bei einer Thermosicherung erreicht, jedoch ohne Zerstörung des Widerstandsnetzwerks durch eine irreversibel ausgelöste Thermosicherung.

In Figur 3 ist eine Widerstandsschicht 2 dargestellt, in der, symmetrisch zur Mittelachse, zwei getrennte Strompfade ausgebildet sind. Generell ist zu beachten, daß die bei Netzberührung auftretende hohe Verlustleistung mit sehr schneller Erwärmung des Substrats 1 nicht zum Zerspringen des meist keramischen Substrats 1 führen darf. Das Substrat 1 muß die auftretende Verlustleistung mit anderen Worten mindestens so lange aushalten, bis der Kaltleiter 3 hochohmig wird und damit die auftretende Leistung begrenzt. Um dies zu erreichen, ist es üblich, diese Verlustleistung über eine große Fläche zu verteilen. Dies wird erreicht durch eine mäanderförmige Ausbildung der Schichtwiderstände 2, wie sie bereits in dem eingangs erwähnten Gebrauchsmuster beschrieben ist.

In Figur 3 sind links und rechts jeweils ein sich von oben nach unten erstreckender Widerstandsmäander dargestellt, wobei beispielsweise das obere Ende des linken Mäanders eine erste Anschlußstelle 11 für den linken Kaltleiter 3 bildet. Die zweite, rechte Anschlußstelle 12 des links dargestellten Kaltleiters 3 ist ohne Mäander senkrecht nach unten zu dem Anschlußpin 7 der Hybridschaltung geführt, während der Anschlußpin 6 als zweiter Anschluß des linken Strompfades dient. Die gezeigte Anordnung der Schichtwiderstände 2 gewährleistet eine relativ gleichmäßige Erwärmung des Substrats 1, d. h. es treten keine sogenannten hot spots auf. Versuche ergaben, daß bei einer Netzberührung eine Erwärmung des Substrats 1 auf 150 °C bereits nach etwa 5 Sekunden, je nachdem, an welcher Stelle die Netzberührung stattfand, erreicht war. Da Kaltleiter mit einer Schaltschwelle von ca. 130 °C aufwärts handelsüblich sind, ist es nicht erforderlich, hot spots zu erzeugen und die Kaltleiter dort zu positionieren, um eine ausreichende Erwärmung zu gewährleisten. Es lassen sich ohne weiteres Schaltzeiten des Kaltleiters 3 von ca. 2 Sekunden erreichen.

Die in Figur 3 dargestellte Ausbildung der Widerstandsschicht 2 mit zwei Strompfaden mit jeweils zwei Anschlußpins 6, 7 bzw. 8,9 und jeweils einem in Reihe zu den Schichtwiderständen 2a, 2b des jeweiligen Strompfades geschalteten Kaltleitern 3a, 3b ist bedingt durch die bei Telekommunikationsanwendungen üblichen A- und B-Leitungen, die für die beiden Sprechrichtungen vorgesehen werden. Dabei besteht die allgemeine Forderung, beispielsweise um die beiden Sprechrichtungen zu entkoppeln, daß der relative Widerstand der Sprechzweige zueinander nur eine Toleranz von etwa ± 0,6 % aufweisen darf. Dies ist im Zusammenhang mit den Kaltleitern 3.a, 3b, die normal eine Widerstandstoleranz von etwa 20 % aufweisen und unter Beachtung der Toleranzstreuungen von ± 15 % der mit dem Kaltleiter in Reihe geschalteten Mäanderwiderstände selbst (nach Drucken und Einbrennen) nicht ohne weiteres erreichbar. Allerdings können die Kaltleiter paarweise bereits mit einer relativen Toleranz von nur ± 5 % geliefert werden. Erfindungsgemäß ist es dann sehr vorteilhaft, wenn die Widerstandsschicht 2a, 2b in jedem Strompfad mäandriert mit mehreren kurzgeschlossenen, vgl. Figur 3, Mäanderschleifen 13 ausgebildet ist, so daß der Gesamtwiderstand der beiden Strompfade relativ zueinander durch Durchtrennung von ausreichend vielen kurzgeschlossenen Mäanderschleifen 13 bis auf eine Toleranz von angenähert ± 0,6 % durch Messung abgleichbar ist. Durch Durchtrennung der Kurzschlüsse 14 wird somit der Nennwert des Gesamtwiderstandes aus Kaltleiter 3a, 3b und Schichtwiderständen 2a, 2b erreicht. Die Mäanderwiderstände 2a, 2b werden im übrigen so angeordnet, daß auch bei nicht durchtrennten Stegen 14 (Widerstandsdruck an der oberen Fertigungstoleranz) eine großflächige und gleichmäßige Verteilung der Verlustleistung gewährleistet ist.

## Patentansprüche

1. Hybridschaltungsanordnung mit einer mindestens einseitig auf einem plattenförmigen Substrat (1) aus Glas oder Keramik aufgebrachten Widerstandsschicht (2) und mit mindestens einer auf dem Substrat (1) angeordneten Überlast-Sicherung, die mit der Widerstandsschicht (2) elektrisch verbunden ist, und die durch einen oberflächenmontierbaren Kaltleiter (PTC) (3) gebildet ist, der an gegenüberliegenden Flächen zwei parallel zum Substrat (1) verlaufende Kontaktflächen aufweist,
**dadurch gekennzeichnet, daß**
die Kontaktflächen (4) jeweils über eine abgewinkelte Kontaktfahne (5) mit der Widerstandsschicht (2) verbunden sind, derart, daß der durch die abgewinkelten Kontaktfahnen (5) mit Abstand zum Substrat (1) angeordnete Kaltleiter (PTC) (3) durch die im Überlastungsfall auftretende Eigenerwärmung hochohmig wird.

2. Hybridschaltungsanordnung nach Anspruch 1,
**dadurch gekennzeichnet,**
- **daß** in der Widerstandsschicht (2) zwei Strompfade mit jeweils zwei Anschlußpins (6, 7; 8, 9) und jeweils einem in Reihe zu den Schichtwiderständen (2a, 2b) des jeweiligen Strompfades geschalteten Kaltleitern (PTC) (3a, 3b) gebildet sind,
- **daß** die Widerstandsschicht (2a, 2b) in jedem Strompfad mäandriert mit mehreren kurzgeschlossenen Mäanderschleifen (13) ausgebildet ist,
- so **daß** der Gesamtwiderstand der beiden Strompfade relativ zueinander durch Durchtrennung von ausreichend vielen kurzgeschlossenen Mäanderschleifen (13) bis auf eine Toleranz von angenähert ± 0,6 % abgleichbar ist.

## Claims

1. A hybrid circuit arrangement having a resistor film (2) which is applied to at least one side of a plate-shaped substrate (1) of glass or ceramic, and having at least one overload protection means which is arranged on the substrate (1), is electrically connected to the resistor film (2) and is formed by a surface-mountable PTC thermistor (PTC) (3) which has on opposing faces two contact faces extending parallel with respect to the substrate (1), **characterised in that**
the contact faces (4) are each connected to the resistor film (2) by way of an angled contact lug (5) in such a way that the PTC thermistor (PTC) (3), arranged spaced from the substrate (1) by the angled contact lugs (5), becomes high-resistance as a result of the self-heating occurring in the event of overload.

2. A hybrid circuit arrangement according to Claim 1, **characterised**
- **in that** two current paths each having two terminal pins (6, 7; 8, 9) and each having a PTC thermistor (PTC) (3a, 3b) connected in series with the film resistors (2a, 2b) of the respective current path are formed in the resistor film (2),
- **in that** the resistor film (2a, 2b) is constructed in serpentine manner in each current path with a plurality of short-circuited serpentine loops (13),
- so **that** the total resistance of the two current paths relative to one another may be compensated down to a tolerance of approximately ± 0.6% by cutting off an adequate number of short-circuited serpentine loops (13).

## Revendications

1. Dispositif de circuit hybride comportant une couche de résistance (2) appliquée au moins sur un côté d'un substrat en forme de plaque (1) composé de verre ou de céramique, et au moins une protection contre une surcharge agencée sur le substrat (1), reliée électriquement à la couche de résistance (2), et constituée par une thermistance (PCT) (3) à montage en surface, comportant au niveau des surfaces opposées deux surfaces de contact s'étendant parallèlement au substrat (1), **caractérisé en ce que**
les surfaces de contact (4) étant reliées respectivement par une languette de contact coudée (5) à la couche de résistance (2), de sorte que la thermistance (PCT) (3) agencée à distance du substrat (1) par l'intermédiaire des languettes de contact coudées (5) assume une valeur ohmique élevée par suite d'un échauffement propre entraîné en cas d'une surcharge.

2. Dispositif de circuit hybride selon la revendication 1, **caractérisé en ce que**
- la couche de résistance (2) comporte deux trajets de courant avec respectivement deux broches de connexion (6, 7; 8, 9) et respectivement une thermistance (PCT) (3a, 3b) montée en série avec les résistances à couche (2a, 2b) du trajet de courant respectif,
- la couche de résistance (2a, 2b) s'étend en méandre dans chaque trajet de courant et comporte plusieurs boucles en méandre court-circuitées (13)
- de sorte que la résistance globale des deux trajets de courant peut être compensée par séparation d'un nombre suffisant de boucles en méandre court-circuitées (13) à une tolérance de l'ordre de ±0,6%.
